# EUROPEAN PATENT APPLICATION

(11) **EP 0 620 589 A1**
(43) Date of publication of application: **19.10.1994**
(21) Application number: 94302067.7
(22) Date of filing: 23.03.1994
(51) Int. Cl.: H01L 21/48

(54) **Leadframe structure for molded package arrangements**

(30) Priority: 30.03.1993 US 40236
(71) Applicant: AT&T Corp., New York, NY 10013-2412 (US)
(72) Inventor: Benzoni, Albert Michael, Trexlertown, Pennsylvania 18087 (US)
(74) Representative: Johnston, Kenneth Graham

(57) **Abstract**

A leadframe structure (18) is proposed for use with a molded package is disclosed. In particular, the structure is suited for arrangements where direct wirebond attachment sites (12) are exposed through the molding material. Conventional molding processes often result in leaving a residue (26) of molding material on the exposed wirebond sites (12). The invention is directed to including a protective layer (24) of material over the wirebond locations (12) during the leadframe plating operation. The protective layer (24)(and any molding residue (26) covering the protective layer) may then be removed using an etchant after the molding operation, exposing the underlying virgin wirebond contact sites (12).

## Description

### Background of the Invention

### Technical Field

The present invention relates to a leadframe structure and, more particularly, to a leadframe structure useful in molded packaging arrangements.

### Description of the Prior Art

In many current integrated electronic and/or optoelectronic circuit arrangements, one or more semiconductor components are positioned on a leadframe and encased in a package, so as to form a single in-line package (SIP) or dual in-line package (DIP) structure. The package may be, in some cases, molded from a plastic to completely encase the circuit components. Typically, electrical signals are transmitted to/from such a molded package to the associated circuit board by the plurality of leads which comprise the leadframe structure. However, in some cases, the need arises to provide a direct electrical contact between the molded package and another device without passing through the circuit board (e.g., in situations where the signal degradation associated with the circuit board is unacceptable).

A problem with the direct wirebond is that an essentially clean wirebond contact on the molded package is required to provide the necessary electrical connections and mechanical integrity. However, inherent in the molding operation is the residue of molding compound (typically, a thermoset resin) which will adhere to the exposed wirebond surface. Conventional cleaning agents, which may be capable of removing the resin from the exposed gold wirebond pad sites, are not acceptable alternatives since they have been found to attack the molded package and/or gold wirebond contact area, as well as require a one-at-a-time cleaning process (costly as compared to a "batch" cleaning system).

A need remains, therefore, for an arrangement capable of improving the electrical quality of wirebond attachments to leadframes utilized in molded packaging arrangements.

### Summary of the Invention

The need remaining in the prior art is addressed by the present invention which relates to a leadframe structure and, more particularly, to a leadframe structure useful in molded packaging arrangements.

In accordance with an exemplary embodiment of the present invention, a conventional copper leadframe (prior to the molding operation) is blanket plated with nickel, then selectively plated (in wirebond locations) or blanket plated with gold. The gold-plated wirebond areas are subsequently plated with a protective material (for example, copper). The structure is then over-molded, using any desired molding process, often resulting in a portion of the molding resin bleeding over into the wirebond sites. After molding, the structure is exposed to an etchant which is selective between nickel and the protective material such that only the protective layer (and resin coating) is removed. Therefore, the underlying leadframe and the virgin gold contact areas of the wirebond sites are exposed.

In one leadframe structure of the present invention, copper may be used as the protective material, where an etchant comprising approximately 10% ammonium hydroxide and 10% HCl may be used.

It is an advantage of the present invention that various combinations of protective materials and etchants may be used to provide for the protection of the wirebond contact.

Other and further advantages of the present invention will become apparent during the course of the following discussion and by reference to the accompanying drawings.

### Brief Description of the Drawing

Referring now to the drawings, where like numerals represent like parts in several views:
FIG. 1 is an exemplary top view of a molded dual in-line package (DIP), illustrating in particular the wirebond locations to be protected during the molding process;
FIG. 2 is a cross-section of the leadframe portion of FIG. 1;
FIG. 3 illustrates an exemplary plated leadframe structure of the present invention; and
FIG. 4 is a cross-section view of a molded DIP package, subsequent to the removal of the protective material.

### Detailed Description

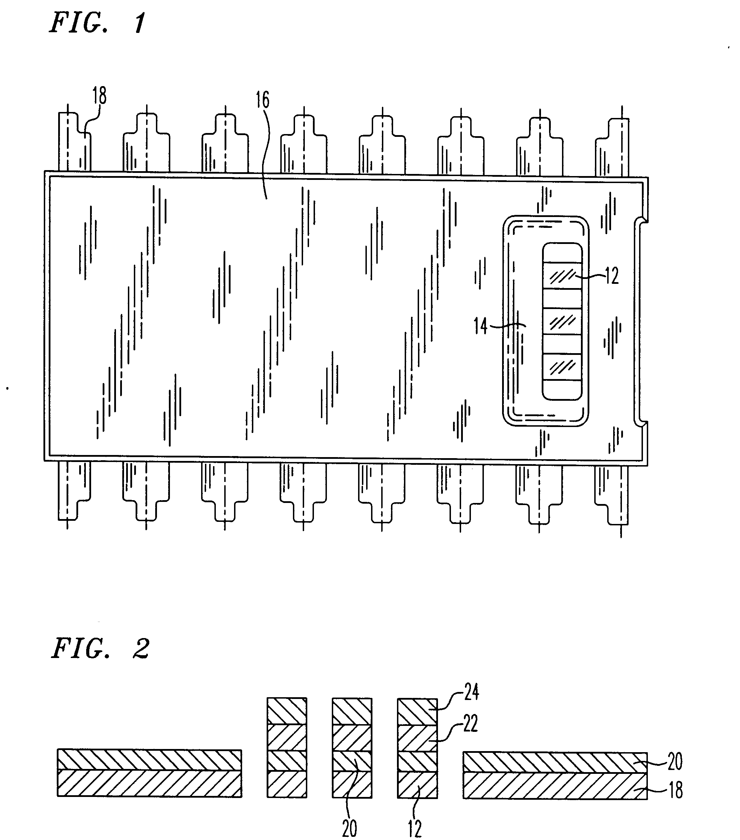

FIG. 1 illustrates an exemplary molded package 10 which contains wirebond locations 12 which may be subject to being covered by resin during the molding operation. As shown, wirebond locations 12, which may comprise gold contacts, are visible through a window 14 formed in a molded package 16. Molded package 16 may comprise any suitable molding compound commonly used for molding operations, for example, a commercially available epoxy molding compound, such as cresol-novolacs. As mentioned above, the molding process may result in a certain amount of the molding material, referred to as resin, "bleeding" onto the wirebond locations. Obviously, the coating of resin over the wirebond sites will adversely affect the integrity of any subsequent wirebond attachment. Therefore, as will be described below, the present invention relates to utilizing a leadframe structure wherein the exposed wirebond sites are covered with a protective (i.e., sacrificial) layer prior to the molding process. The protective layer is then removed after the molding process, taking with it the resin coating. The underlying metal (e.g., gold) wirebond sites are then exposed and may be used to provide robust mechanical and electrical contacts.

An exemplary leadframe 18, including wirebond locations 12 is illustrated in FIG. 2. Leadframe 18 may comprise any suitable material, where in most conventional embodiments, a copper leadframe is used. In the conventional processing of a leadframe, the copper leadframe may also be blanket plated with a nickel layer 20. An intermediate layer of metallization, for example, silver, may be included at this location of the structure. In accordance with the leadframe structure of the present invention, the locations of wirebond sites, denoted 12 in FIG. 2, are further plated with the material 22 to be used to form the bond pads for the wirebond contacts. For example, gold may be used to form plated layer 22. As shown in FIG. 2, a protective layer 24 is formed so as to cover layer 22. Protective layer 24 must comprise a material which may later be removed by an etch process, using an etchant which will not affect the rest of the nickel-plated copper leadframe 18, underlying contact layer 22, or plastic packaging. In one embodiment, copper may be used to form protective plating layer 24.

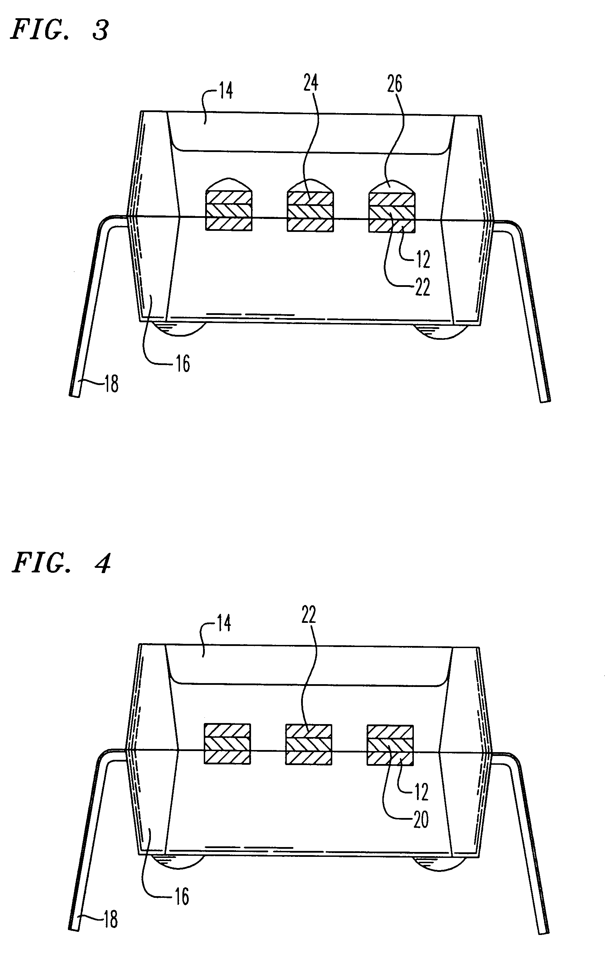

A cut-away side view of a molded package 16 including a plated leadframe 18 as discussed above is illustrated in FIG.3. As shown, a residue 26 of the molding material (resin) has coated protective layer 24. In accordance with the teaching of the present invention, residue 26 is then removed by using an etchant which will preferentially etch protective layer 24 with respect to the remaining leadframe material. For example, when copper is used to form protective layer 24, an etchant comprising 10% ammonium hydroxide and 10% HCl may be used.

FIG. 4 contains a cut-away side view of an exemplary molded package after the removal of residue 26 and protective layer 24 with the etchant. As shown, the removal of these layers allows for the contact layer 22 (usually gold) to be exposed and available for wirebond attachments.

As mentioned above, various other materials (and associated etchants) may be used to form protective layer 24. For example, silver, may also be used. It is to be understood that many other materials may also be used and are considered to fall within the spirit and scope of the present invention.

## Claims

1. A leadframe structure comprising
a plurality of sites for the location of wirebonds;
contact material disposed to cover said plurality of wirebond sites; and
protective material disposed to cover said contact material so as to protect the integrity of said contact material during subsequent molding operations.

2. A leadframe structure as defined in claim 1 wherein the leadframe comprises a nickel-plated copper leadframe.

3. A leadframe structure as defined in claim 1 wherein the contact material comprises gold.

4. A leadframe structure as defined in claim 1 wherein the protective material comprises copper.
